# EUROPEAN PATENT APPLICATION

(11) **EP 4 284 150 A1**
(43) Date of publication of application: **29.11.2023**
(21) Application number: 22886473.2
(22) Date of filing: 08.09.2022
(51) Int. Cl.: H10N 30/853, C04B 35/495, H10N 30/06, H10N 30/097, H10N 30/50, H10N 30/87

(54) **PIEZOELECTRIC ELEMENT AND METHOD FOR MANUFACTURING PIEZOELECTRIC ELEMENT**

(30) Priority: 29.10.2021 JP 2021177332
(71) Applicant: Niterra Co., Ltd., Nagoya-shi, Aichi 461-0005 (JP)
(72) Inventor: HIROSE, Yoshinobu, Nagoya-shi, Aichi 461-0005 (JP); ICHIHASHI, Kentaro, Nagoya-shi, Aichi 461-0005 (JP); KASASHIMA, Takashi, Nagoya-shi, Aichi 461-0005 (JP); YAMAZAKI, Masato, Nagoya-shi, Aichi 461-0005 (JP)
(74) Representative: Grünecker Patent- und Rechtsanwälte PartG mbB
(86) International application number: PCT/JP2022/033711
(87) International publication number: WO 2023/074139

(57) **Abstract**

A piezoelectric element having a piezoelectric body and an electrode in contact with the piezoelectric body: the piezoelectric body being formed of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and the electrode containing a base metal as a main component.

## Description

### TECHNICAL FIELD

The techniques disclosed by the present specification relate to a piezoelectric element and a method for producing a piezoelectric element.

### BACKGROUND ART

Hitherto, PZT (lead zirconate titanate) has been widely used as a ceramic material exhibiting piezoelectricity. However, PZT, containing a lead component, evokes a problematic impact on the environment, and thus demand has arisen for development of a piezoelectric ceramic containing no lead.

Also, electronic parts employing a piezoelectric ceramic are generally produced by stacking ceramic green sheets that are to serve as piezoelectric ceramic layers and electrically conductive films that are to serve as electrodes, and co-firing the two components. As an electrode material, Pt, Ag-Pd alloy, and similar materials are widely used. However, these electrode materials are expensive and readily evoke migration. Thus, in recent years, Ni (nickel) has been proposed as an alternative material which is inexpensive and in which migration is suppressed. Since Ni readily undergoes oxidation when fired in air, such firing must be conducted in a reducing atmosphere. In the case where Ni is co-fired with a piezoelectric ceramic material, for example, a lead-containing zirconate titanate material or a lead titanate material, lead is chemically reduced in the atmosphere. In such a case, a reliable piezoelectric characteristic fails to be attained.

In recent years' research in finding a lead-free piezoelectric ceramic material which contains no lead and which can exhibit piezoelectricity even after firing in a reducing atmosphere, there have been developed, as promising candidates, a variety of lead-free piezoelectric ceramic compositions containing an alkali niobate-based perovskite oxide as a primary phase (see, Patent Literatures 1 and 2).

### CITATION LIST

### PATENT LITERATURE

Patent Literature 1: JP 5862983B
Patent Literature 2: JP 6489333B

### SUMMARY OF INVENTION

### TECHNICAL PROBLEM

The aforementioned lead-free piezoelectric ceramic compositions exhibit a dielectric loss (tanδ) of about 5%, and such a considerably large dielectric loss may affect characteristics including insulation performance. If such a ceramic composition is subjected to a polarization treatment including application of a strong electrical field at a temperature of some tens of degrees Celsius or to operation a device employing the composition, leakage or dielectric breakdown, as well as temperature elevation may readily occur.

### SOLUTION TO PROBLEM

The present specification discloses a piezoelectric element having a piezoelectric body and an electrode in contact with the piezoelectric body, the piezoelectric body being formed of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and the electrode containing a base metal as a main component.

The present specification also discloses a method for producing a piezoelectric element, the method including: a calcination step of mixing raw materials of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and firing the raw materials, to thereby yield a calcined powder; a shaping step of forming a compact containing the calcined powder; an electrode formation step of forming, on the compact, an electrode layer containing a base metal as a main component; and a co-firing step of firing the compact together with the electrode layer in a reducing atmosphere.

### ADVANTAGEOUS EFFECTS OF INVENTION

According to the piezoelectric element and the method for producing the piezoelectric element which are disclosed in the present specification, dielectric loss can be reduced, and insulation performance can be improved.

### BRIEF DESCRIPTION OF DRAWINGS

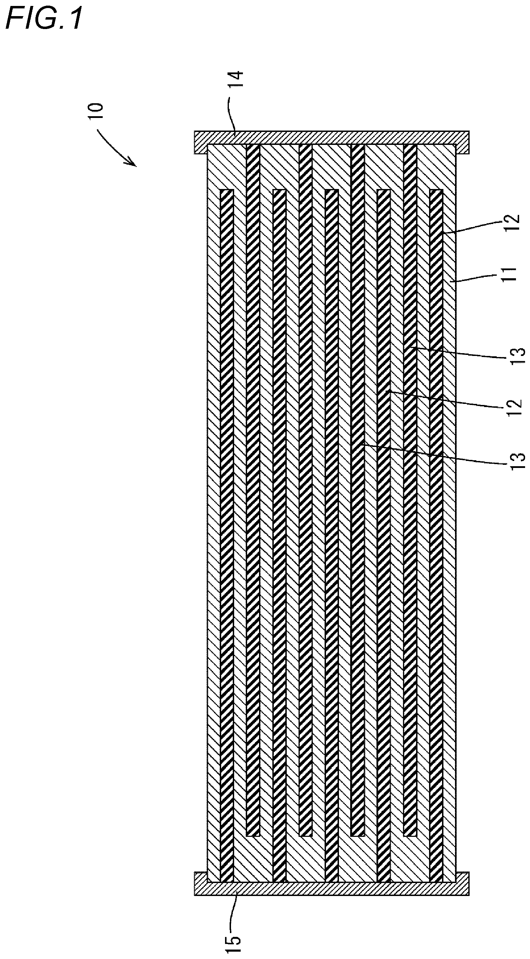

[FIG. 1] Sectional view of a piezoelectric element of an embodiment.

### DESCRIPTION OF EMBODIMENTS

### [Summary of embodiment]

(1) The piezoelectric element disclosed by the present specification has a piezoelectric body and an electrode in contact with the piezoelectric body, the piezoelectric body being formed of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and the electrode containing a base metal as a main component.

The piezoelectric element production method disclosed by the present specification includes a calcination step of mixing raw materials of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and firing the raw materials, to thereby yield a calcined powder; a shaping step of forming a compact containing the calcined powder; an electrode formation step of forming, on the compact, an electrode layer containing a base metal as a main component; and a co-firing step of firing the compact together with the electrode layer in a reducing atmosphere.

According to the aforementioned technical features, suitable amounts of Ti, Zr, and Hf are incorporated into B sites (niobium sites) of the alkali niobate-based perovskite oxide, whereby sinterability to form the piezoelectric body is improved. As a result, dielectric loss is lowered, and insulation performance is improved.

Conceivably, when Mn serving as an acceptor forms a solid solution in B sites, loss of electric charges attributable to oxygen vacancy provided during firing in a reducing atmosphere can be compensated. In this case, dielectric loss is lowered, and insulation performance is improved. However, difficulty is encountered in formation of a solid solution of Mn with an alkali niobate-based perovskite oxide, and Mn tends to segregate to form a foreign phase in the lead-free piezoelectric ceramic composition. When Ba, Ca, and Sr are incorporated into A sites (alkali sites) to form a solid solution, piezoelectric performance is enhanced. However, since Ba, Ca, and Sr serve as donors, the piezoelectric body may assume a semiconducting feature, possibly resulting in a disadvantageous drop in insulation performance.

Also conceivably, by adjusting compositional proportions of Ti, Zr, and Hf to Ba, Ca, and Sr to satisfy the condition: b/(d3+d4+d 5)≤1, a semiconducting phenomenon attributed to incorporation of Ba, Ca, and Sr into A sites to form a solid solution is suppressed, while suitable amounts of Ti, Zr, Hf, and Mn are incorporated to form a solid solution. In this case, dielectric loss is lowered, and insulation performance is improved.

2) In the piezoelectric element of 1) above, the ratio by mole of Mn atoms contained in the primary phase to Nb atoms contained in the primary phase (Mn/Nb) may be 0.003 or more.

In the piezoelectric element production method of 1) above, in the calcination step, the ratio by mole of Mn atoms contained in the mixture of the raw materials to Nb atoms contained in the mixture of the raw materials (Mn/Nb) may be 0.005 or more.

By adjusting the ratio by mole of Mn atoms to Nb atoms in the above manner, the dielectric loss of the piezoelectric body can be reliably reduced, to thereby improve insulation performance.

3) In the piezoelectric element of 1) above, crystal grains of the alkali niobate-based perovskite oxide contained in the primary phase may have a mean grain size less than 6 µm.

When the mean grain size of the crystal grains is less than 6 µm, grain boundary resistance increases. Thus, an undesired drop in piezoelectric property can be prevented.

4) In the piezoelectric element of 1) above, the lead-free piezoelectric ceramic composition may further include a secondary phase formed of one member of a compound represented by compositional formula A2₁₋ₓTi₁₋ₓNb₁₊ₓO₅ (wherein element A2 is at least one species among the alkali metals, and the condition: 0≤x≤0 .15 is satisfied) and a compound represented by compositional formula A3Ti₃NbO₉ (wherein element A3 is at least one species among the alkali metals).

According to the above technical feature, the piezoelectric performance can be further enhanced, as compared with the case in which the lead-free piezoelectric ceramic composition includes no secondary phase.

5) The piezoelectric element of 1) above may have a structure in which the piezoelectric body and the electrode are alternately stacked.

### [Details of embodiment]

Specific examples of the techniques disclosed in the present specification will now be described with reference to the drawings. Notably, the examples should not be construed as limiting the invention thereto, and the scope of the present invention is defined by the claims. It is also intended that the present invention encompasses all modifications within the meanings and scopes equivalent to those of the claims.

### <Embodiment>

### [Piezoelectric element 10]

A piezoelectric element 10 of the present embodiment includes piezoelectric layers 11 (an example of the piezoelectric body); a plurality of internal electrodes 12, 13 (examples of the electrodes) which are in contact with the piezoelectric layers 11; and two external electrodes 14, 15 which are connected to the internal electrodes 13, 12. The piezoelectric layers 11 are formed from a lead-free piezoelectric ceramic composition including a primary phase formed of an alkali niobate-based perovskite oxide. The internal electrodes 12, 13 are formed mainly from a base metal, such as Ni (nickel). The piezoelectric layers 11 and the internal electrodes 12, 13 are alternately stacked. More specifically, the piezoelectric layers 11 and the internal electrodes 12, 13 are stacked in the stacking order of the piezoelectric layer 11, the internal electrode 12, the piezoelectric layer 11, the internal electrode 13, the piezoelectric layer 11, and so forth. One piezoelectric layer 11 is sandwiched by two internal electrodes 12, 13. The two external electrode 14, 15 are disposed on the outer surface of the stacked body including the piezoelectric layers 11 and the internal electrodes 12, 13. Of two internal electrodes 12, 13 which are in contact with one piezoelectric layer 11, one internal electrode 12 is connected, at its one end, to one external electrode 14, and the other internal electrode 13 is connected, at its one end, to the other external electrode 15. Through application of a voltage between the external electrodes 14, 15, the piezoelectric layers 11 expand and contract, whereby the entirety of the piezoelectric element 10 expands and contracts.

### [Technical feature of lead-free piezoelectric ceramic composition]

The lead-free piezoelectric ceramic composition forming the piezoelectric layers 11 includes a primary phase formed of an alkali niobate-based perovskite oxide which exhibits a piezoelectric property. The alkali niobate-based perovskite oxide of the present embodiment is represented by the following compositional formula (1).

(AlₐM1_{b})_{c}(Nb_{d1}Mn_{d2}Ti_{d3}Zr_{d4}Hf_{d5})O₃₊ₑ ··· (1)

In formula (1), element A1 is at least one species among alkali metals, and element M1 is at least one species among alkaline earth metals of Ca (calcium), Sr (strontium), and Ba (barium).

In the above compositional formula (1), element A1 and element M1 are located in A sites (alkali sites) of the perovskite structure, and Nb (niobium), Mn (manganese), Ti (titanium), Zr (zirconium), and Hf (hafnium) are located in B sites.

In the compositional formula (1), coefficients a to e are selected from the values which are preferred from the viewpoints of electrical characteristics and piezoelectric characteristics (in particular, piezoelectric constant d33) of the lead-free piezoelectric ceramic composition, so long as the coefficients a to e ensure establishment of the perovskite structure.

Specifically, coefficients a and b satisfy the conditions: 0<a<1, 0<b<1, and a+b=1. However, the cases of a=0 (i.e., the composition containing no alkali metal) and b=0 (i.e., the composition containing none of Ca, Sr, and Ba) are excluded.

Coefficient c with respect to the entire A sites satisfies 0.80<c<1.10, and is preferably 0. 84≤c≤1.08, more preferably 0.88≤c≤1.07.

Coefficients d1, d2, d3, d4, and d5 satisfy the conditions: 0<d1<1, 0<d2<1, 0<d3<1, 0≤d4<1, 0≤d5<1, and d1+d2+d3+d4+d5=1. However, the cases of d1=0 (i.e., the composition containing no Nb, d2=0 (i.e., the composition containing no Mn), and d3=0 (i.e., the composition containing no Ti) are excluded. Coefficient d4 with respect to Zr and coefficient d5 with respect to Hf may be 0 (i.e., the composition not containing Zr and/or Hf).

In coefficient (3+e) with respect to oxygen, the value of e is a positive or negative value showing deviation (deficiency or excess) from the intrinsic value of 3 with respect to oxygen. Coefficient (3+e) with respect to oxygen may be a value which allows the primary phase to have a perovskite oxide structure. Typically, coefficient e is 0, and preferably satisfies 0≤e≤0.1. Notably, coefficient e may also be calculated from the composition of the primary phase to meet the electrically neutral condition. However, needless to say, a composition of the primary phase which is slightly deviated from the electrically neutral condition is also allowable.

Coefficients b, d3, d4, and d5 satisfy the condition: b/(d3+d4+d5)<1. When coefficients b, d3, d4, and d5 satisfy the condition, a lead-free piezoelectric ceramic composition which exhibits low dielectric loss and high insulation performance can be yielded. A conceivable reason for this is as follows.

Since suitable amounts of Ti, Zr, and Hf are incorporated into B sites (niobium sites) of the alkali niobate-based perovskite oxide, sinterability to form the piezoelectric body is improved. As a result, dielectric loss is lowered, and insulation performance is improved.

Also conceivably, when Mn serving as an acceptor forms a solid solution in B sites, loss of electric charges attributable to oxygen vacancy provided during firing in a reducing atmosphere can be compensated. In this case, dielectric loss is lowered, and insulation performance is improved. However, difficulty is encountered in formation of a solid solution of Mn with an alkali niobate-based perovskite oxide, and Mn tends to segregate to form a foreign phase in the lead-free piezoelectric ceramic composition. When Ba, Ca, and Sr are incorporated into A sites (alkali sites) to form a solid solution, piezoelectric performance is enhanced. However, since Ba, Ca, and Sr serve as donors, the piezoelectric body may assume a semiconducting feature, possibly resulting in a disadvantageous drop in insulation performance.

Also conceivably, by adjusting compositional proportions of Ti, Zr, and Hf to Ba, Ca, and Sr to satisfy b/(d3+d4+d 5)≤1, a semiconducting phenomenon attributed to incorporation of Ba, Ca, and Sr into A sites to form a solid solution is suppressed, while suitable amounts of Ti, Zr, Hf, and Mn are incorporated to form a solid solution. In this case, dielectric loss is lowered, and insulation performance is improved.

The alkali niobate-based perovskite oxide represented by the aforementioned compositional formula (1) preferably contains, as element A1, at least one species among K (potassium), Na (sodium), and Li (lithium). When the above oxide contains at least one species of K, Na, and Li as element A1 and at least one species of Ca, Sr, and Ba as element M1, compositional formula (1) can be transformed into the following compositional formula (1a).

(Kₐ₁Naₐ₂Liₐ₃Ca_{b1}Sr_{b2}Ba_{b3})_{c}(Nb_{d1}Mn_{d2}Ti_{d3}Zr_{d4}Hf_{d5})O₃₊ₑ ··· (1a)

The aforementioned compositional formula (1) is equivalent to the above formula (1a), and the conditions: a1+a2+a3=a and b1+b2+b3=b, are satisfied. Typically, coefficients a1 and a2 with respect to K and Na satisfy the conditions: 0<a1≤0.6 and 0<a2≤0.6, respectively. Coefficient a3 with respect to Li may be 0 and is preferably 0<a3≤0.2, more preferably 0<a3≤0.1.

Among the alkali niobate-based perovskite oxides represented by compositional formula (1a), those containing K, Na, and Nb as main metallic components are called "KNN" or "KNN material." A lead-free piezoelectric ceramic composition, which is produced by use of such an oxide, can exert excellent piezoelectric characteristics, electric characteristics, insulation performance, and durability at high temperatures and does not exhibit steep variation in these characteristics within a temperature range of -50°C to +150°C. Atypical composition of the primary phase is (K, Na, Li, Ca, Ba)_{c}(Nb, Mn, Ti, Zr, Hf)O₃₊ₑ.

The lead-free piezoelectric ceramic composition of this embodiment may further include a secondary phase formed of one member of an oxide represented by the following compositional formula (2) and an oxide represented by the following compositional formula (3).

A2₁₋ₓTi₁₋ₓNb₁₊ₓO₅ ··· (2)

A3Ti₃NbO₉ ··· (3)

In compositional formula (2), element A2 is at least one species among alkali metals, preferably at least one species among K, Rb (rubidium), and Cs (cesium). Coefficient x satisfies the condition: 0≤x≤0 .15. When coefficient x satisfies this condition, the secondary phase has a stable structure, thereby yielding a uniform crystalline phase. From the viewpoint of structural stability of the secondary phase, coefficient x preferably satisfies the condition: 0≤x≤0.15 in the case in which element A2 is K or Rb, and the condition: 0≤x≤0.10 in the case in which element A2 is Cs.

In compositional formula (3), element A3 is at least one species among alkali metals, preferably at least one species among K, Rb, and Cs.

The secondary phase itself has no piezoelectric property. However, when the secondary phase is co-present with the primary phase, sinterability and insulation performance can be enhanced. Also, the secondary phase may prevent phase transition within a range of -50°C to +150°C. The secondary phase assumes a compound having a layer structure (i.e., a layer compound). Conceivably, the layer structure of the compound may be a factor for enhancing insulation performance of the piezoelectric ceramic composition and preventing phase transition.

The secondary phase content may be more than 0 mol% and less than 20 mol%, and is preferably 2 mol% or more and 15 mol% or less, more preferably 2 mol% or more and 10 mol% or less.

Among the oxides represented by compositional formula (2) or (3), those containing Nb, Ti, and K as main metallic components are called "NTK material." By use of such an oxide, a lead-free piezoelectric ceramic composition which is inexpensive and exhibits excellent piezoelectric characteristics can be provided.

The ratio by mole of Mn atoms contained in the primary phase to Nb atoms contained in the primary phase (Mn/Nb) is preferably 0.003 or more. By adjusting the mole ratio in the above manner, dielectric loss of the piezoelectric layers 11 can be reliably reduced, thereby improving insulation performance.

The crystal grains of the alkali niobate-based perovskite oxide contained in the primary phase preferably have a mean grain size less than 6 µm. When the mean grain size of the crystal grains is less than 6 µm, grain boundary resistance increases. Thus, an undesired drop in piezoelectric property can be prevented.

### [Method of producing piezoelectric element 10]

An example of the method of producing the aforementioned piezoelectric element 10 will next be described.

### 1. Calcination step

First, essential ingredients for producing a primary phase are chosen from powder-form raw materials, and weighed so as to attain a target composition. The powder-form raw materials may be an oxide, a carbonate salt, or a hydroxide of an element forming the primary phase. In this procedure, the ratio by mole of Mn atoms contained in the powder-form raw materials of the primary phase to Nb atoms contained in the powder-form raw materials of the primary phase (Mn/Nb) is adjusted to be 0.005 or more. To these powder-form raw materials, ethanol is added, and the mixture is agitated under wet conditions by means of a ball mill for preferably 15 hours or longer, to thereby prepare a slurry. In one mode, the thus-prepared slurry is dried, and the dry powder mixture is calcined at 600 to 1,000°C in air for 1 to 10 hours, to thereby yield a calcined product of the primary phase (calcination step).

No particular limitation is imposed on the upper limit of the ratio by mole of Mn atoms contained in the powder-form raw materials of the primary phase to Nb atoms contained in the powder-form raw materials of the primary phase (Mn/Nb), but the ratio by mole (Mn/Nb) is preferably 0.1 or less. When the ratio by mole (Mn/Nb) is in excess of 0.1, sintering may be impeded.

Separately, essential ingredients for producing a secondary phase are chosen from powder-form raw materials, and weighed so as to attain a target composition. The powder-form raw materials may be an oxide, a carbonate salt, or a hydroxide of an element forming the secondary phase. To these powder-form raw materials, ethanol is added, and the mixture is agitated under wet conditions by means of a ball mill for preferably 15 hours or longer, to thereby prepare a slurry. In one mode, the thus-prepared slurry is dried, and the dry powder mixture is calcined at 600 to 1,000°C in air for 1 to 10 hours, to thereby yield a calcined product of the secondary phase.

Subsequently, a calcined product of the primary phase and that of the secondary phase are weighed, and a dispersant, a binder, and an organic solvent (e.g., toluene) are added to the weighed mixture. The resultant mixture is pulverized and agitated, to thereby form a slurry. Then, the slurry is formed into a sheet through a doctor blade technique or the like, to thereby form a ceramic green sheet (an example of the compact) (shaping step).

Next, a conductive paste for forming an internal electrode is applied to a surface of the ceramic green sheet through a technique, such as screen printing, to thereby form an electrode layer serving as an internal electrode (electrode formation step). The electrode layer is mainly formed of a base metal (e.g., Ni).

A plurality of units of the ceramic green sheet on which the electrode layer has been formed are stacked together, and another ceramic green sheet having no electrode layer is placed on each of the surface of the stacked body. The product is pressed, to thereby yield a stacked body in which ceramic green sheets and electrode layers have been alternately stacked. The stacked body is cut into a shape of interest and subjected to a debindering treatment (e.g., maintaining the stacked body at 200 to 400°C for 2 to 10 hours).

After debindering, the stacked body is fired under specific conditions (e.g., maintaining at 900 to 1,200°C in a reducing atmosphere for 2 to 5 hours). The oxygen partial pressure of the firing atmosphere is adjusted so that the electrode layers are not oxidized (co-firing step).

After firing, Au external electrodes are formed on the outer surface of the stacked body through a technique, such as sputtering, and the product is subjected to a polarization treatment, to thereby fabricate a piezoelectric element.

Notably, the production method as described above is a merely an exemplary method, and various other steps and treatment conditions for producing a piezoelectric element may be employed. In the above production procedure, a calcined product of the primary phase and that of the secondary phase are separately formed, and the two products are mixed, followed by firing. However, in an alternative method, raw materials of the primary phase and those of the secondary phase are mixed at such a ratio that the target compositional proportions of the finally obtained lead-free piezoelectric ceramic composition are attained, and the thus-prepared mixture is fired. Through the former method, rigorous control of the composition of the primary phase and that of the secondary phase can be easily achieved, whereby the yield of the lead-free piezoelectric ceramic composition can be enhanced.

The lead-free piezoelectric ceramic composition and the piezoelectric element according to the present embodiment find various uses including vibration sensing, pressure sensing, oscillation, and piezoelectric devices. Specific examples include sensors for detecting various vibrations (e.g., a knocking sensor and a combustion pressure sensor); piezoelectric devices such as an oscillator, an actuator, and a filter; high-voltage generators; micro power supplies; driving units; position control systems; vibration dampers; and fluid discharge systems (e.g., a paint ejector and a fuel ejector). In addition, the lead-free piezoelectric ceramic composition and the piezoelectric element according to the present embodiment are particularly suitable for uses requiring extremely high heat resistance (e.g., a knocking sensor and a combustion pressure sensor).

In the present embodiment, the piezoelectric element 10 has a configuration in which piezoelectric layers 11 and internal electrodes 12, 13 are alternately stacked. Alternatively, the piezoelectric element may have a single-layer structure including one layer of a piezoelectric body, and electrodes provided on the piezoelectric body.

### <Test Examples>

### 1. Test Example 1

### (1) Sample preparation

Powders of K₂CO₃, Na₂CO₃, and Nb₂O₅ were weighed so that coefficients f and g of the following compositional formula (2) were adjusted to specific values shown in Table 1. The weighed powders were mixed together.

(K_{f}Na_{g})NbO₃ ··· (2)

Separately, BaCO₃ powder, CaCO₃ powder, and SrCO₃ powder were weighed so that the total mol% of Ba atoms, Ca atoms, and Sr atoms with respect to Nb atoms present in the Nb₂O₅ powder was adjusted to a specific value shown in Table 1. An essential ingredient or ingredients was/were added to the mixture of K₂CO₃, Na₂CO₃, and Nb₂O₅. Also, MnO₂ powder, TiO₂ powder, ZrO₂ powder, and HfO₂ powder were weighed so that the mol% of atom of each additional metal with respect to Nb atoms present in the Nb₂O₅ powder was adjusted to a specific value shown in Table 1, and the ingredients were added to the mixture of K₂CO₃, Na₂CO₃, and Nb₂O₅.

In each case, ethanol was added to the thus-prepared powder-form raw material, and the resultant mixture was agitated under wet conditions by means of a ball mill for 15 hours or longer, to thereby prepare a slurry. The slurry was dried, and the dry powder mixture was calcined at 600 to 1,000°C in air for 1 to 10 hours, to thereby yield a calcined product powder.

To the thus-obtained calcined product powder, a dispersant, a binder, and an organic solvent (e.g., toluene) were added, and the resultant mixture was pulverized and agitated, to thereby form a slurry. Thereafter, the slurry was formed into a sheet through a doctor blade technique, to thereby form ceramic green sheets. A plurality of the ceramic green sheets were stacked under application of pressure, and the pressed body was cut into a disk-form compact.

Onto each surface of the compact, a conductive paste for forming an electrode was applied through screen printing, to thereby from an electrode layer (electrode formation step). As shown in Table 2, the electrode component content of the conductive pastes used for forming an electrode was adjusted to 100% (Ni) in the case of samples No. 1 to 24, and 90 mass% (Cu) and 10 mass% (Ni) in the case of sample No. 25.

Each of the compacts provided with electrode layers was maintained at 200 to 400°C for 2 to 10 hours for debindering. Then, co-firing was performed at 900 to 1,200°C for 2 to 5 hours in a reducing atmosphere in which the oxygen partial pressure was controlled to inhibit oxidation of the electrode layers. The thus-obtained fired product was subjected to a polarization treatment in silicone oil at 50°C under application of an electric field of 5 kv/mm, to thereby provide a sample. The obtained sample was a piezoelectric element having a piezoelectric body and an electrode layer formed on each surface of the piezoelectric body, in which the piezoelectric body was formed from a lead-free piezoelectric ceramic composition containing an alkali niobate-based perovskite oxide represented by compositional formula (1a).

**[Table 1]**

| SAMPLE No. | f | g | M1 ELEMENT | | | Ti | Zr | Hf | Mn |
|---|---|---|---|---|---|---|---|---|---|
| | | | Ba | Ca | Sr | | | | |
| | | | AMOUNT mol% | AMOUNT mol% | AMOUNT mol% | AMOUNT mol% | AMOUNT mol% | AMOUNT mol% | AMOUNT mol% |
| 1 | 0.48 | 0.52 | 6 | - | - | 2 | 2 | 0 | 5 |
| 2 | 0.48 | 0.52 | 3 | 3 | - | 2 | 2 | 0 | 5 |
| 3 | 0.48 | 0.52 | 2 | - | - | 2 | 2 | 0 | 0 |
| 4 | 0.48 | 0.52 | 2 | - | - | 0 | 5 | 0 | 5 |
| 5 | 0.48 | 0.52 | 4 | - | - | 2 | 2 | 0 | 5 |
| 6 | 0.48 | 0.52 | 2 | - | - | 2 | 2 | 0 | 5 |
| 7 | 0.48 | 0.52 | 2 | - | - | 4 | 2 | 0 | 5 |
| 8 | 0.48 | 0.52 | 1 | - | - | 5 | 1 | 0 | 5 |
| 9 | 0.48 | 0.52 | 2 | - | - | 1 | 2 | 0 | 5 |
| 10 | 0.48 | 0.52 | 2 | - | - | 2 | 2 | 0 | 0.1 |
| 11 | 0.48 | 0.52 | 2 | - | - | 2 | 2 | 0 | 0.5 |
| 12 | 0.48 | 0.52 | 2 | - | - | 2 | 2 | 0 | 1 |
| 13 | 0.48 | 0.52 | 2 | - | - | 2 | 2 | 0 | 7 |
| 14 | 0.48 | 0.52 | 2 | - | - | 4 | 0 | 0 | 5 |
| 15 | 0.48 | 0.52 | 2 | - | - | 1 | 3 | 0 | 5 |
| 16 | 0.48 | 0.52 | - | 2 | - | 2 | 2 | 0 | 1 |
| 17 | 0.48 | 0.52 | - | - | 2 | 2 | 2 | 0 | 1 |
| 18 | 0.48 | 0.52 | 1 | 1 | - | 2 | 2 | 0 | 1 |
| 19 | 0.48 | 0.52 | 7 | - | - | 5 | 2 | 0 | 5 |
| 20 | 0.10 | 0.90 | 2 | - | - | 2 | 2 | 0 | 5 |
| 21 | 0.70 | 0.30 | 2 | - | - | 2 | 2 | 0 | 5 |
| 22 | 0.48 | 0.52 | 5 | - | - | 5 | 7 | 0 | 5 |
| 23 | 0.48 | 0.52 | 4 | - | - | 2 | 0 | 2 | 5 |
| 24 | 0.48 | 0.52 | 4 | - | - | 2 | 1 | 1 | 5 |
| 25 | 0.48 | 0.52 | 4 | - | - | 2 | 2 | 0 | 5 |

### (2) Test method

Each of the produced samples was analyzed by means of an impedance analyzer (E4990A, product of Keysight Technologies). By use of an electrostatic capacity at room temperature and 1 kHz, dielectric loss tanδ was calculated. In addition, electromechanical coupling coefficient kp was determined through a resonance-antiresonance system. When a sample exhibited a dielectric loss tanδ of 3.0% or less and an electromechanical coupling coefficient kp of 20% or higher, the sample was evaluated as a good (i.e., nondefective) product.

Also, each of the produced samples was subjected to a dielectric breakdown test. In a specific test procedure, an electric field of 5 kv/mm was applied for 30 minutes or longer to the sample placed in silicon oil at 50°C, and occurrence of dielectric breakdown was checked. The case of occurrence of dielectric breakdown was assessed as rating "X" and the case of no occurrence of dielectric breakdown was assessed as rating "O."

### (3) Results

P_{M1}/(P_{Ti}+P_{Zr}+P_{Hf}) of each sample was calculated, wherein P_{M1} is a total mol% of Ba atoms, Ca atoms, and Sr atoms with respect to Nb atoms present in the raw material powder mixture weighed in 1.(1) above, and P_{Ti}, P_{Zr}, and P_{Hf} are a mol% of Ti atoms, a mol% of Zr atoms, and a mol% of Hf atoms, with respect to Nb atoms, respectively. Further, each sample was subjected to elemental analysis by means of an electron probe microanalyzer (EPMA). The analysis was performed at three points (grains) of the primary phase with a beam size of φ 1 µm, whereby the ratio by mole of Mn atoms contained in the main phase to Nb atoms contained in the main phase was determined. The ratio by mole of Mn atoms to Nb atoms (Mn/Nb) was an averaged values determined at the three points. Table 2 shows these values, along with values of dielectric loss tanδ, electromechanical coupling coefficient kp, and results of the dielectric breakdown test.

**[Table 2]**

| SAMPLE No. | ELECTRODE | P_{M1}/(P_{Ti}+P_{Zr}+P_{Hf}) | Mn/Nb | ELECTROMECH. COUPLING COEFF. kp % | INSULATION | DIELECTRIC LOSS tan δ % |
|---|---|---|---|---|---|---|
| 1 | Ni | 1.5 | 0.031 | - | × | 5.3 |
| 2 | Ni | 1.5 | 0.031 | - | × | 6.1 |
| 3 | Ni | 0.5 | 0.000 | - | × | 7.3 |
| 4 | Ni | 0.4 | 0.032 | - | × | 10.3 |
| 5 | Ni | 1.0 | 0.031 | 30 | ○ | 2.4 |
| 6 | Ni | 0.5 | 0.031 | 31 | ○ | 2.3 |
| 7 | Ni | 0.3 | 0.032 | 33 | ○ | 1.9 |
| 8 | Ni | 0.2 | 0.032 | 31 | ○ | 2.2 |
| 9 | Ni | 0.7 | 0.031 | 28 | ○ | 2.3 |
| 10 | Ni | 0.5 | 0.001 | - | × | 5.8 |
| 11 | Ni | 0.5 | 0.003 | 26 | ○ | 2.8 |
| 12 | Ni | 0.5 | 0.006 | 28 | ○ | 2.6 |
| 13 | Ni | 0.5 | 0.044 | 27 | ○ | 2.8 |
| 14 | Ni | 0.5 | 0.031 | 30 | ○ | 2.8 |
| 15 | Ni | 0.5 | 0.031 | 25 | ○ | 2.4 |
| 16 | Ni | 0.5 | 0.006 | 27 | ○ | 2.7 |
| 17 | Ni | 0.5 | 0.006 | 26 | ○ | 2.8 |
| 18 | Ni | 0.5 | 0.006 | 26 | ○ | 2.7 |
| 19 | Ni | 1.0 | 0.032 | 25 | ○ | 2.8 |
| 20 | Ni | 0.5 | 0.031 | 24 | ○ | 2.9 |
| 21 | Ni | 0.5 | 0.031 | 24 | ○ | 2.5 |
| 22 | Ni | 0.4 | 0.034 | 33 | ○ | 2.0 |
| 23 | Ni | 1.0 | 0.031 | 30 | ○ | 2.2 |
| 24 | Ni | 1.0 | 0.031 | 29 | ○ | 2.3 |
| 25 | Cu:Ni=9:1 | 1.0 | 0.031 | 28 | ○ | 2.6 |

Theoretically, Ca atoms, Sr atoms, and Ba atoms which are present in raw material powders completely enter the A sites of the alkali niobate-based perovskite oxide, and Ti atoms, Zr atoms, and Hf atoms completely enter the B sites of the alkali niobate-based perovskite oxide. Therefore, the total mol% of Ba atoms, Ca atoms, Sr atoms (P_{M1}) may correspond to the sum of coefficients b 1, b2, and b3 to Ba, Ca, and Sr of compositional formula (1a) (i.e., coefficient b of compositional formula (1)), and the mol% of Ti atoms, Zr atoms, and Hf atoms may correspond to coefficient d3, d4, and d5 to Ti, Zr, and Hf in compositional formula (1), respectively. Thus, the equation in terms of mol%: P_{M1}/(P_{Ti}+P_{Zr}+P_{Hf}), may be equivalent to the equation: b/(d3+d4+d5), regarding coefficients b, d2, and d3 of compositional formula (1).

Samples Nos. 1 and 2, having a P_{M1}/(P_{Ti}+P_{Zr}+P_{Hf}) value (i.e., b/(d3+d4+d5) value) of 1 or more, exhibited a dielectric loss of 3.0% or more and underwent dielectric breakdown in the dielectric breakdown test. Also, sample No. 3, containing no Mn, exhibited a dielectric loss of 3.0% or more and underwent dielectric breakdown in the dielectric breakdown test. Similarly, sample No. 4, containing no Ti, exhibited a dielectric loss of 3.0% or more and underwent dielectric breakdown in the dielectric breakdown test. Furthermore, sample No. 10, having a mol% of Mn atoms contained in the raw material mixture to Nb atoms contained in the raw material powder of 0.1% (i.e., having a mol ratio of Mn atoms contained in the raw material mixture to Nb atoms contained in the raw material mixture (Mn/Nb) of 0.001), exhibited a dielectric loss of 3.0% or more and underwent dielectric breakdown in the dielectric breakdown test.

Each of samples Nos. 5 to 9 and Nos. 11 to 25 essentially contained element A1 (at least one of alkali metals), element M1 (at least one of Ba, Ca, and Sr), and Mn and Ti. These samples had a P_{M1}/(P_{Ti}+P_{Zr}+P_{Hf}) value (i.e., b/(d3+d4+d5) value) less than 1; a mol% of Mn atoms contained in the raw material mixture to Nb atoms contained in the raw material mixture of 0.5% or more (i.e., having a mol ratio of Mn atoms contained in the raw material mixture to Nb atoms contained in the raw material mixture (Mn/Nb) of 0.005 or more); and a ratio by mole of Mn atoms to Nb atoms contained in the primary phase (Mn/Nb) of 0.003 or more. These samples were found to exhibit a dielectric loss of 3.0% or less and an electromechanical coupling coefficient of 20% or higher, and to undergo no dielectric breakdown in the dielectric breakdown test, indicating excellent piezoelectric characteristics.

### 2. Test Example 2

### (1) Preparation of samples and test method

In a manner similar to that of Test Example 1, samples Nos. 26 to 29, having the same composition as that of sample No. 5, were produced (see Table 3). These samples were prepared through a firing step employing various firing temperatures. As a result, the grain size of crystal grains forming the alkali niobate-based perovskite oxide was modified.

**[Table 3]**

| SAMPLE No. | f | g | M1 ELEMENT | Ti | Zr | Mn | P_{M1}/(P_{Ti}+P _{Zr}+P _{Hf}) |
|---|---|---|---|---|---|---|---|
| | | | Ba | | | | |
| | | | AMOUNT mol% | AMOUNT mol% | AMOUNT mol% | AMOUNT mol% | |
| 5 | 0.48 | 0.52 | 2 | 2 | 2 | 5 | 0.5 |
| 26 | 0.48 | 0.52 | 2 | 2 | 2 | 5 | 0.5 |
| 27 | 0.48 | 0.52 | 2 | 2 | 2 | 5 | 0.5 |
| 28 | 0.48 | 0.52 | 2 | 2 | 2 | 5 | 0.5 |
| 29 | 0.48 | 0.52 | 2 | 2 | 2 | 5 | 0.5 |

The thus-prepared samples were subjected to image analysis (x5,000) by means of an SEM (TM4000 Plus, product of Hitachi High-Tech Corporation). In each image, the average value of grain size of crystal grains observed in the image was employed as a mean grain size. The prepared samples were subjected to the same test as Test Example 1, whereby dielectric loss tanδ and electromechanical coupling coefficient kp were determined. The same dielectric breakdown test was also performed.

### (2) Results

Table 4 shows dielectric loss tanδ, electromechanical coupling coefficient kp, and the results of dielectric breakdown test of the samples, along with mean particle size.

**[Table 4]**

| SAMPLE No. | MEAN GRAIN SIZE um | ELECTROMECH. COUPLING COEFF. kp % | INSULATION | DIELECTRIC LOSS tan δ % |
|---|---|---|---|---|
| 5 | 2.3 | 31 | ○ | 2.3 |
| 26 | 4.5 | 28 | ○ | 2.6 |
| 27 | 1.5 | 26 | ○ | 2.1 |
| 28 | 5.3 | 25 | ○ | 2.8 |
| 29 | 6.0 | 18 | × | 3.8 |

Sample No. 29, having a mean grain size of crystal grains of 6 µm, exhibited a dielectric loss of 3.0% or more and underwent dielectric breakdown in the dielectric breakdown test. In contrast, Samples No. 5 and Nos. 26 to 28, having a mean grain size of crystal grains less than 6 µm, exhibited a dielectric loss of 3.0% or less and an electromechanical coupling coefficient of 20% or higher, and underwent no dielectric breakdown in the dielectric breakdown test, indicating excellent piezoelectric characteristics.

### REFERENCE SIGNS LIST

10: piezoelectric element
11: piezoelectric layer (piezoelectric body)
12, 13: internal electrode (electrode)

## Claims

1. A piezoelectric element having a piezoelectric body and an electrode in contact with the piezoelectric body:
the piezoelectric body being formed of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and
the electrode containing a base metal as a main component.

2. The piezoelectric element according to claim 1, wherein the ratio by mole of Mn atoms contained in the primary phase to Nb atoms contained in the primary phase (Mn/Nb) is 0.003 or more.

3. The piezoelectric element according to claim 1 or 2, wherein crystal grains of the alkali niobate-based perovskite oxide contained in the primary phase have a mean grain size less than 6 µm.

4. The piezoelectric element according to any one of claims 1 to 3, wherein the lead-free piezoelectric ceramic composition includes a secondary phase formed of one member of a compound represented by compositional formula A2₁₋ₓTi₁₋ₓNb₁₊ₓO₅ (wherein element A2 is at least one species among the alkali metals, and the condition: 0≤x≤0 .15 is satisfied) and a compound represented by compositional formula A3Ti₃NbO₉ (wherein element A3 is at least one species among the alkali metals).

5. The piezoelectric element according to any one of claims 1 to 4, which has a structure in which the piezoelectric body and the electrode are alternately stacked.

6. A method for producing a piezoelectric element, the method comprising:
a calcination step of mixing raw materials of a lead-free piezoelectric ceramic composition which includes a primary phase formed of an alkali niobate-based perovskite oxide represented by a compositional formula (A1ₐM1_{b})_{c}(Nb_{d1}Mn_{d2}Ti_{d3}Zr_{d4}Hf_{d5})O₃₊ₑ (wherein element A1 represents at least one species among the alkali metals; element M1 represents at least one species among Ba, Ca, and Sr; the following conditions: 0<a<1, 0<b<1, a+b=1, 0.80<c<1.10, 0<d1<1, 0<d2<1, 0<d3<1, 0≤d4<1, 0≤d5<1, and d1+d2+d3+d4+d5=1, are satisfied; and e represents a value showing the degree of deficiency or excess of oxygen) and which satisfies the condition: b/(d3+d4+d5)≤1, and firing the raw materials, to thereby yield a calcined powder;
a shaping step of forming a compact containing the calcined powder;
an electrode formation step of forming, on the compact, an electrode layer containing a base metal as a main component; and
a co-firing step of firing the compact together with the electrode layer in a reducing atmosphere.

7. The method for producing a piezoelectric element according to claim 6, in the calcination step, the ratio by mole of Mn atoms contained in the mixture of the raw materials to Nb atoms contained in the mixture of the raw materials (Mn/Nb) may be 0.005 or more.
